# EUROPEAN PATENT SPECIFICATION

(11) **EP 1 676 310 B1**
(45) Date of publication and mention of the grant of the patent: **25.03.2015**
(21) Application number: 04791232.4
(22) Date of filing: 14.10.2004
(51) Int. Cl.: H01L 21/762, H01L 21/304

(54) **METHOD FOR PREPARING AND ASSEMBLING SUBSTRATES**
VERFAHREN ZUR HERSTELLUNG UND ZUSAMMENSTELLUNG VON SUBSTRATEN
PROCEDE DE PREPARATION ET D'ASSEMBLAGE DE SUBSTRATS

(30) Priority: 14.10.2003 FR 0350674; 07.05.2004 US 568700 P
(43) Date of publication of application: 05.07.2006
(60) Divisional application: 10177601.1
(73) Proprietor: Soitec, 38190 Bernin (FR)
(72) Inventor: ASPAR, Bernard, F-38140 Rives (FR); LAGAHE-BLANCHARD, Chrystelle, F-38134 Saint Joseph De Rivière (FR)
(74) Representative: Ahner, Philippe
(86) International application number: PCT/EP2004/052548
(87) International publication number: WO 2005/038903

(56) References cited:
- EP-A- 1 026 728
- EP-A- 1 059 663
- EP-A- 1 189 266
- WO-A-2004/008525
- WO-A-2004/081974
- US-A- 5 476 566
- US-A1- 2002 187 595
- US-B1- 6 309 950
- PATENT ABSTRACTS OF JAPAN vol. 2000, no. 09, 13 October 2000 (2000-10-13) -& JP 2000 173961 A (SHARP CORP), 23 June 2000 (2000-06-23)
- PATENT ABSTRACTS OF JAPAN vol. 2000, no. 03, 30 March 2000 (2000-03-30) -& JP 11 354761 A (SUMITOMO METAL IND LTD), 24 December 1999 (1999-12-24)

## Description

### Technical field and prior art

The invention relates to the field of assembling wafers or slices or layers of material, notably semiconductors, and of their preparation with the purpose of assembling them.

Among the assembly techniques of such substrates, molecular adhesion allows to assemble flat structures of low surface roughness.

It allows to obtain unique structures and is particularly well adapted for bonding together wafers of material used in microelectronics, such as, for example, wafers in silicon, or III-V material (AsGa, InP) or glass or fused silica or vitreous fused silica glass substrates.

Nowadays this technique is used industrially, for example in the manufacture of SOI (Silicon On Insulator) material.

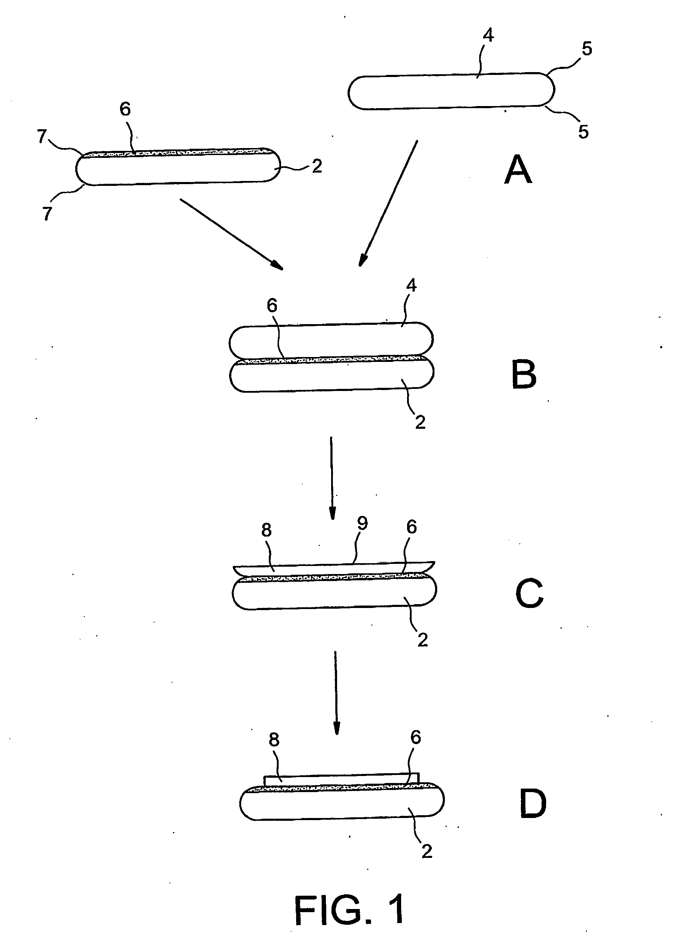

The known methods for manufacturing SOI material, which use molecular adhesion, implement two wafers 2, 4 of silicon (figure 1, part A), of which at least one of the two has a layer 6 of oxide on the surface.

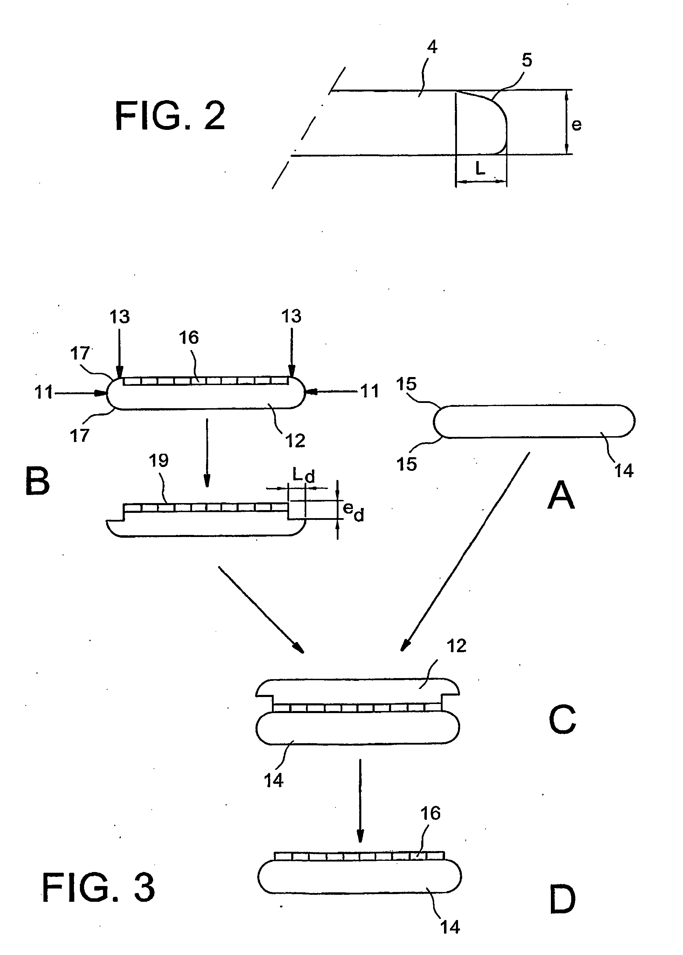

These two wafers are of standard size. The edges 5 and 7 are generally chamfered, so as to avoid fractures likely to appear during eventual manufacturing of components or in the event of shocks to still sharp edges. There are rounded and/or bevelled chamfers. Figure 2 represents, in greater detail, an example of a chamfer zone 5, of width L (measured on a plane parallel to the mean plane P of the wafer) of a wafer 4, of thickness e.

The assembling firstly comprises a surface preparation stage, a putting together stage (figure 1, part B), generally followed by a heat treatment stage.

Normally, this heat treatment is performed at 1100°C for 2 hours for SOI substrates.

Then, as illustrated in figure 1, part C, at least one of the two wafers is thinned out via surface edge grinding and/or mechanical polishing and/or mechano-chemical polishing.

The chamfers 5 and 7 generate the existence of a non-bonded zone on the wafer edges.

After thinning out, a membrane 8 made in silicon remains bonded to the centre, but detached on the edges, as visible in figure 1, part C.

The detached edge of the membrane must be removed, as it is likely to break in an uncontrolled manner and introduce particles on the other surfaces, and notably on surface 9 of the membrane 8, or on components made in the membrane 8.

For this reason a stage for routing or eliminating matter in the peripheral zone is performed in order to eliminate this edge zone from the membrane 8, as illustrated in figure 1, part D.

This routing is normally performed via mechanical means.

This stage is very delicate. For example, in the event of mechanical machining, it is difficult to route or trim everything and to stop exactly at the bonding interface, which in this case is the upper surface of the oxide layer 6. Indeed, either we stop just above this interface leaving some matter above the latter, or we stop in the support 2 and the surface polish of the edges of the front face of the support is lost.

It is therefore important to find a means of properly and accurately routing or trimming a wafer of material.

This phenomenon is also important in the case where at least one of the two wafers contains all or part of an electronic or opto-electronic device, or a micro-system, or a nano-system or another component.

The same problem exists if the assembling of the two wafers is done via bonding instead of molecular adhesion, or even without the oxide layer 6 on the surface of the wafer 12.

Another problem is the marking of one or both of the two wafers 2 and 4, generally on the support wafer, with the purpose of providing specific information such as for example identification information of a batch. For example, on SOI wafers, due to their multilayer nature, a marking, generally via etching, induces a greater number of particles than on bulk wafers.

Document JP 20000173961 discloses a method to provide a semiconductor device manufacturing method which does not produce any cracks or chips in the peripheral part of a semiconductor device substrate, even if back grinding which makes the substrate thickness to several tens of um or less is performed.

To this end chamfering parts of a wafer are ground by thickness a little bit deeper than a target substrate thickness of back grinding. A semi conductor device protecting tape is applied to the flat part. After that, the back of the wafer is ground with a back grinding stone.

Document US 5476566 discloses a method for thinning a semiconductor wafer. A laminated semiconductor wafer structure is assembled to provide mechanical support for the wafer. A semiconductor wafer is affixed to a UV transparent support substrate with a double-sided adhesive tape. The tape has a UV curable adhesive on its two sides. The first side has a UV curable adhesive that adheres to the active surface of the wafer. The second side has a non-UV curable adhesive which adheres to the UV transparent support substrate. This laminated structure can be used during a wafer thinning process and any subsequent handling. The support substrate and the tape are removed from the wafer by exposing the laminated structure to UV radiation.

### PRESENTATION OF THE INVENTION

The invention is defined by the subject-matter of independent claim 1.

The invention firstly relates to a method according to claim 1 for assembling a first and a second wafer of material, comprising:
- a routing or trimming stage of at least the first wafer;
- an assembling stage of at least the first wafer, routed or trimmed, and of the second wafer.

According to the invention, a machining, or routing or eliminating or trimming stage of the matter in a peripheral section of at least the first wafer, is thus performed before bonding or assembling the two wafers together.

A thinning out stage of at least the first wafer can then be carried out, leaving a layer on the second wafer. A transplanting or transferring of this layer is thus achieved.

The invention also relates to a method according to claim 1 for transplanting or transferring a layer of material, circuits or components, known as transplant or transfer layer, comprising:
- the routing or trimming of a first wafer of material, or the elimination of matter in a peripheral section of a first wafer, in which the transplant layer or the layer to transfer is made, at least in a zone located around or on the periphery of this transplant layer;
- the transplanting or transferring of this layer onto a second wafer of material.

This transplanting or transferring is performed via assembling the first and second wafers and then thinning out the first wafer.

The first wafer of the method for assembling, transplanting or transferring is a chamfered wafer, bearing at least one chamfered edge. The routing or trimming thus relates to the chamfered edge. It can also eat into a part, normally peripheral, of the transplant or transfer layer.

The method for assembling or transplanting according to the invention thus allows to obtain a structure with a first wafer perfectly routed before assembling, the routing or trimming being devoid of the problems developed above in the context of the prior art, problems due to the existence of a second wafer.

It can apply as much to wafers containing all or part of an electronic component or other, as to blank wafers, such as wafers known as "bulk".

Routing or trimming stages before assembling can be performed before or after possible surface preparation stages with the purpose of assembling or transplanting.

The first wafer is trimmed over a thickness greater than the final thickness of the layer that is transplanted onto the second wafer.

If the substrates or wafers have comparable initial dimensions or initial diameters, the thickness of the routing or trimming can be such that the routed wafer has, after routing or trimming, a dimension or diameter less than the other wafer.

The trimming stage is performed over a width Ld, measured on a plane parallel to that of the first wafer, at least equal to the width L of the chamfered edge, measured on the same plane.

The routing stage can also be performed over a width greater than or equal to the width of the zone of the first wafer which can not be bonded or assembled due to the rollover or chamfer.

The first wafer can have a zone or a weakened or cleavage or fracture plane, created in depth for example by hydrogen implantation or by the creation of a buried porous zone or by the creation of a removable bonding interface.

When the thickness of the routed zone is greater than the thickness of the desired thin layer, this routed wafer can be recycled, without the need of routing before bonding onto a new substrate. A new weakened a cleavage or fracture plane can thus be created, then it can be directly assembled with a new substrate.

The assembling of the two wafers can be performed via molecular adhesion or via bonding, through the adding of matter such as for example adhesive or wax.

The routing or trimming stage can be performed in a regular manner around the first wafer.

It can also be performed in an irregular manner around the first wafer, creating one or more flats or flat surfaces.

The routing or trimming stage can also be performed in an irregular manner, creating at least one marking zone in at least one of the wafers. A marking stage in at least one of these marking zones can then be carried out.

According to another aspect the object of the invention is also a method according to claim 1 for assembling a first and a second wafer of material, comprising:
- an assembling stage of the first wafer and of the second wafer;
- a routing or trimming stage of at least the first wafer and the creating of at least a marking zone and/or at least an irregular zone on the periphery of the first and/or the second wafer.

The first wafer has at least one chamfered edge.

The invention thus allows to make a specific zone, for example with the purpose of marking a wafer, whether the routing or trimming takes place before or after the assembling of the wafers.

When routing or trimming takes place after assembling, a thinning out stage of one of the two wafers can take place before or after routing or trimming, leaving at least one layer on the other wafer.

When routing takes place after assembling, the process can comprise one or several of the following characteristics or stages:
- the routing or trimming can take place over the entire thickness of the routed wafer;
- and/or at least one of the two wafers can be processed, that meaning have components or circuits;
- and/or the routing or trimming stage is performed over a width Ld, measured on a plane parallel to that of the first wafer, of between 100 µm and 5 mm;
- and/or the first or the second wafer can be chamfered, and have at least one chamfered edge;
- and/or the routing or trimming stage can be performed over a width Ld, measured on a plane parallel to that of the first wafer, at least equal to the width L of the chamfered edge, measured on the same plane;
- and/or the assembling of the two substrates can be performed via molecular adhesion or via bonding using an adhesive substance;
- and/or the routing or trimming can be performed via mechanical, chemical or mechano-chemical etching or via plasma etching or via a combination of at least two of these types of etching;
- and/or at least one of the two wafers can be made in a semiconductor material, for example in silicon or in a III-V type semiconductor material;
- and/or at least one of the two wafers can be made in Germanium or in Germanium silicon or in a piezoelectric material or in an insulating material.

### BRIEF DESCRIPTION OF THE FIGURES

Figure 1, parts A-D, represents stages of a known method for assembling substrates.
Figure 2 represents a part of a substrate and its edge or rollover edge.
Figure 3, parts A-D, represents stages of a method according to the invention.
Figures 4, parts A-C, and 5, parts A-B, represent an alternative of a method not being part of the invention.
Figure 6, parts A-E, represents an alternative of a method according to the invention, in the case of a substrate with a weakened plane.
Figure 7, parts A-D, represents an alternative of a method according to the invention, in the case of a substrate with a protective or bonding layer.
Figures 8A-8D represent a front view of the routed or trimmed wafers.
Figure 9 represents a wafer of material with a lateral shoulder.
Figures 10A-10B represent a wafer with an embedding.

### EXAMPLES OF EMBODIMENTS OF THE INVENTION

Figure 3, parts A-D, represents stages of a method according to the invention.

Two wafers 12 and 14 are chosen, for example two wafers of semiconductor material, such as standard silicon wafers.

These wafers can typically have a thickness of between 300 µm and 800 µm. They are for example wafers of 100 mm or 200 mm or 300 mm in diameter.

For the aforementioned reasons, the edges 15 and 17 are chamfered.

Components or circuits 16 have previously been made in the wafer 12, the reference 16 thus designating a layer of material to be transplanted or transferred onto the wafer 14. In figure 3, part B, the surface of this layer 16 of circuits or material to be transplanted or transferred lies flush with the surface of the wafer 12.

A routing or matter eliminating or trimming stage is then performed (figure 3, part B), starting from the face 19 of the wafer 12 (thus following a direction indicated by the arrows 13) to be assembled with the wafer 14, over a thickness ed and a width Ld. It is also possible to perform a routing or trimming in the direction indicated by the arrows 11, that meaning substantially parallel to the principal plane of the wafer 12. A routing or trimming in the two combined directions is also possible.

The width Ld is measured on a plane parallel to the mean plane of the wafer. This routing or trimming stage, performed before the assembling or transplanting stage onto the wafer 14, allows to eliminate, at least partially and from the assembly face 19 or from its lateral edges, the matter located in the peripheral zone, or located around the transplant layer 16, zone which is likely to have problems caused by the non-bonded edges.

Ld is greater than or equal to the width L of the rollover edge or the chamfer (figure 2). It can be from about a few hundred µm to a few mm, for example of between 100 µm and 5 mm.

Ld is notably greater than L in the case where the non-bonding zone or zone which can not adhere to a substrate after assembling, as illustrated in stage C of figure 1, is itself greater than L.

Indeed, this "non-bonding" or "non-assembling" zone depends on the manner the rollover edge is made on the wafer 12 but also on the wafer 14.

It can also depend on the technical stages that could have been previously performed on the upper wafer 12 and on the support wafer 14. Regarding the width L, some stages can increase the width of this non-bonded zone (for example oxidising or depositing stages), others can reduce this said width (for example a levelling or flattening or polishing stage).

Ld can therefore be greater than or equal to the width of this non-bonding or non-assembling zone.

The thickness ed will be less than the thickness e of the wafer. It is greater than the thickness of the layer 16 (stage D, figure 3) to be obtained after the future thinning out or transplanting stage onto the wafer 14.

By way of example ed can be about a few µm or between 1 µm (or 10 µm) and 100 µm or even between 5 µm and 60 µm. As for the layer 16, it can have a thickness, for example, between 1 µm and 60 µm.

The routing or trimming stage before assembling can be performed in a mechanical and/or chemical (notably humid) and/or mechano-chemical manner and/or via plasma. The mechanic routing can be performed for example via "edge grinding" or "edge polishing".

It then proceeds with the assembling of the two wafers (stage C, figure 3) for example via molecular adhesion.

As explained above, the assembling comprises for example a surface preparation stage, a putting into contact stage and a heat treatment stage.

This heat treatment stage is performed at a few hundred degrees Celsius, for example between 100 and 1200°C, or even 1100°C, and this for a time span from a few minutes to a few hours, for example between 10 minutes and 3 hours, or even 2 hours.

Then, as illustrated in figure 3 (stage D), at least one of the two wafers is thinned down to the desired thickness, for example over a thickness greater than or equal to e-ed, via edge grinding and/or mechanical polishing and/or mechano-chemical polishing and/or chemical polishing. In figure 3 (stage D), the thinned wafer is the previously routed wafer 13.

After thinning out of the latter, a membrane made in semiconductor material, or even the layer 16 of components or circuits, thus remains bonded or assembled to the wafer 14, towards its centre. There are no lateral membranes nor any non-bonded lateral residue. The transplanting or transferring of the layer 16 is thus better than with the technology of the prior art.

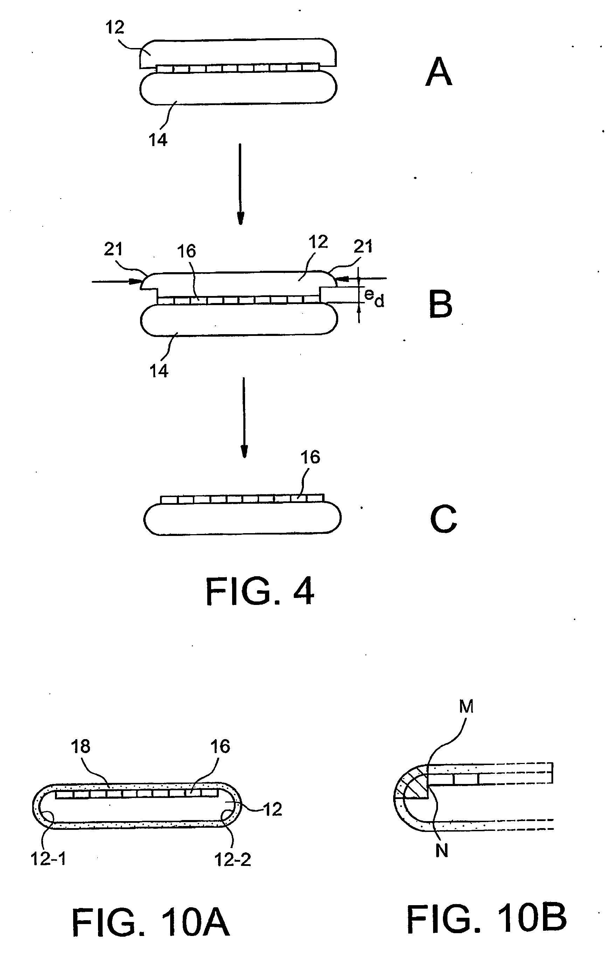

Figure 4, part A, corresponds to the aforementioned case, not being part of the present invention, where the depth ed over which the wafer 12 was routed before assembling is insufficient to completely remove the layer 16 during the thinning out stage.

Assembling, which has led to the structure of figure 4, part A, can thus be followed with an additional routing or trimming, from the edges 13 located on the side of the front face or from the assembling face, in order to obtain a routed zone over a thickness ed greater than that of the layer 16 (figure 4, part B).

It is also possible to perform this additional routing or trimming from the edges 21 located on the rear face, opposite the assembling face, or even laterally, in the direction of the arrows 11 indicated in figure 4B.

This additional routing or trimming stage is free of the problems disclosed in the introduction to this application: there is notably no risk of spoiling or etching out the substrate 14. It can then be followed by the thinning out stage of the substrate 12, as described above (figure 4, part C).

Here again we obtain a transplant or a transfer free of membrane or lateral residue.

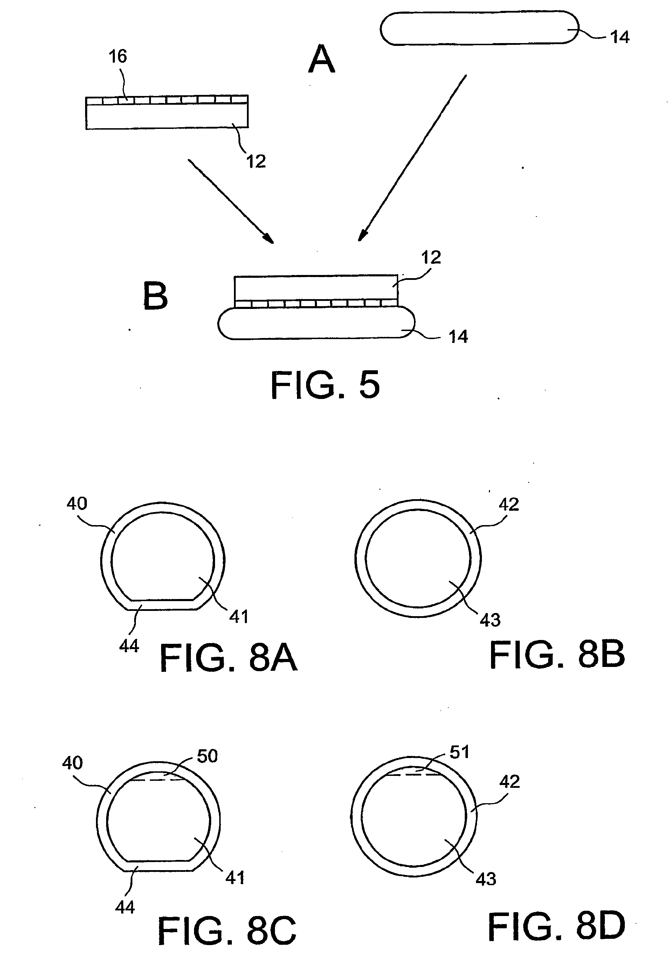

According to an alternative, not being part of the present invention, the wafer 12 is completely routed over its entire thickness (figure 5, part A). This is the case where ed=e.

The assembling stage leads to the device represented in figure 5, part B, which can then be thinned out as explained above.

The wafer 12 then has a width or diameter less than that of the wafer 14.

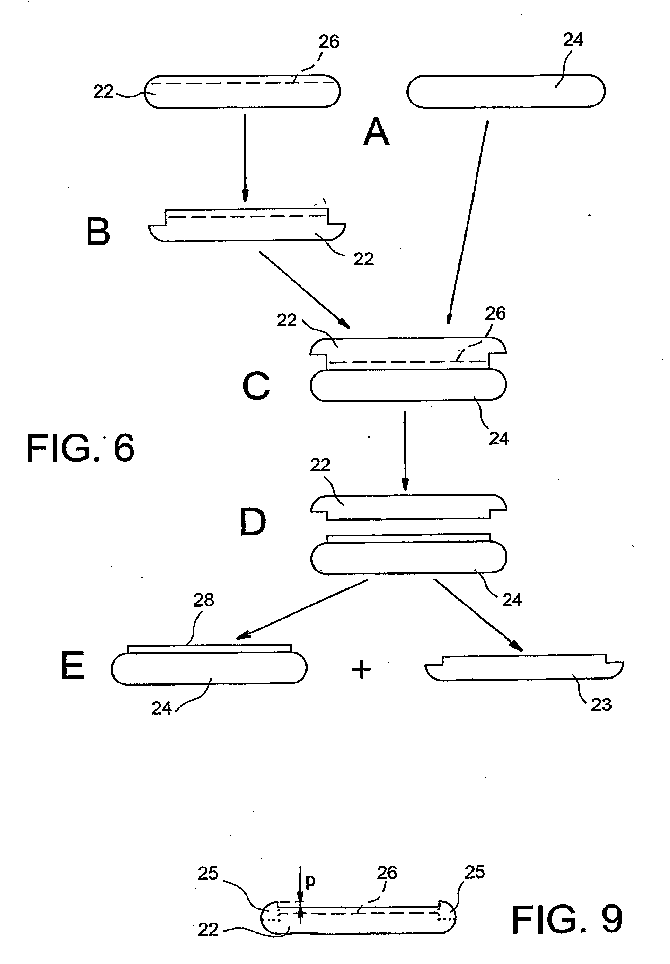

As illustrated in figure 6, part A, the invention also applies to an initial substrate 22 in which a weakened or fracture plane 26 was made, for example via previous ion implantation (for example a hydrogen implantation) or via creating a buried porous zone, as explained for example in the document by S.S.Iyer and al. "Silicon wafer bonding technology for VLST and MEMS applications", published by INSPEC, 2002, Antony Rowe Ltd, or via creating a removable bonding interface.

It then proceeds with the routing or trimming of this substrate (figure 6, part B) over a part of its thickness, as explained above, then with the assembling of the two substrates 22 and 24.

For example, a heat treatment allows to separate the substrate 22 on the ion implantation layer 26 of hydrogen ions (figure 6, part D).

This results, on one hand in a unit made of the substrate 24 with a superficial layer 28 of material which comes from the initial substrate 22, and on the other hand in a substrate or a free portion 23 which also comes from the initial substrate 22 and which is reusable for subsequent operations. If the thickness over which the substrate 22 was routed or trimmed is greater than the thickness of the transplant layer 28, this substrate 22 can notably be subjected to a new ion or atom implantation, then a new transferring or transplanting stage after assembling with a new substrate 24, but without the need to perform a new routing or trimming stage.

The invention, such as is described above in connection with one of the figures 3-6, also applies in the case where the initial substrate 12 and 22 has the shape illustrated in figure 9, with a shoulder 25 on the edges of the wafer.

These shoulders define a stiffening located at a depth P, for example lying between 50 nm and 2 µm.

The routing stage allows to remove these shoulders.

An ion implantation stage, for the creating of a weakened plane 26, can take place before or after this routing or trimming stage: a wafer is thus obtained which is identical to the one represented in part B of figure 6. The following stages in figure 6 can thus be performed as described above.

BSOI or thick SOI type structures can also be created in an efficient manner. The thinning out stage is then mechanic and/or mechano-chemical.

According to another example, electronic components are made in a wafer such as the wafer 12 (figure 3A) over a superficial thickness, for example, between 1 and 10 µm.

We rout or trim via "surface edge grinding" the edge of the wafer over a thickness ed of 50 µm and along a width Ld of 3 mm.

This routing stage can be performed before surface preparation (for example via mechano-chemical levelling followed by chemical cleaning) and in order to reduce the number of cleansings before assembling.

Then the routed wafer (comprising the components) is bonded via molecular adhesion onto the support wafer. The structure is then annealed for example at a temperature of 300°C and for a time span of between a few minutes and a few hours.

The superficial wafer is then thinned out via surface edge grinding and mechano-chemical (figure 3, part D) and/or chemical polishing until a thickness de is obtained, for example, 10 µm.

A transplanted layer, comprising the components, transferred onto a support wafer is thus obtained.

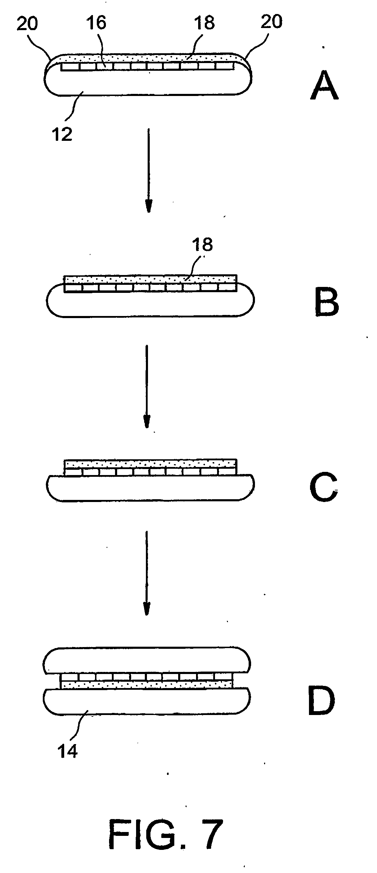

According to another embodiment, the wafer 12 comprises components 16 and is covered on its surface with a protective layer 18, for example an oxide layer 18 (figure 7, part A). This can also be a bonding layer.

A crown 20 is defined via lithography which will correspond to the routing zone. A local chemical etching allows to eliminate, on this zone, the protective layer 18 (figure 7, part B).

The edge of the substrate 12 is then etched (figure 7, part C), for example via chemical (ex. TMAH) or plasma etching.

The wafer is then cleaned, for example via chemical cleaning. According to an alternative, the cleaning is integrated into the chemical etching.

It can then proceed with the assembling on a wafer 14 as explained above (figure 7, part D).

According to an alternative in figure 10A and 10B, a protective layer 18 initially coats the entire upper section of the wafer 12 as well as the edges 12-1 and 12-2, and possibly its lower section (in which case it coats the entire wafer).

The routing operation will allow to eliminate the lateral zones of this wafer such as the hatched zone in figure 10B. A possible scaling or clearing due to the routing operation occurs at the point M of the coating layer 18 or in a zone of this layer near this point. A scaling occurring on the wafer can generate defects, some of which can show on the surface of the wafer. A point of the surface to be assembled, such as point N, remains intact despite routing. The protective layer 18 can be eliminated after routing and before assembling.

Figures 8A-8D each represent a front view of a wafer 40 and 42 with a layer 41 and 43 of material around which routing was performed. This layer 41 and 43 is intended to be transplanted or transferred onto a second wafer, according to any one of the aforementioned embodiments. In figure 8A the wafer has a flat or a flattered zone 44.

An irregular routing can be performed, as illustrated in figures 8C-8D. In these figures, the zones 50 and 51 represent zones or flats or flat surfaces which will allow to mark the support wafer. The zone 44 in figure 8A can also be used to mark the wafer.

Such a zone allows to provide indications regarding the nature of the wafer or an identification number of a batch to which the wafer belongs.

Irregular routing, such as in figures 8A, 8C and 8D can also be performed when routing is performed after assembling, thus using the standard routing technique such as is illustrated in figures 1A-1D, and possibly with one or two processed wafers, thus comprising all or part of a component or circuit. In this case, the other processing stages can be those already described above.

In particular, one of the wafers can have a chamfered edge, the routing can thus take place over a width at least equal to the width of the chamfered edge, measured on a plane parallel to that of the wafer.

The assembling can take place via molecular adhesion or via bonding.

Generally, the invention has the advantage of being able to be integrated into a method for manufacturing. This is notably the case when components are previously made in the wafers.

The method set forth in the invention is also well suited to the manufacturing of BSOI type material, or even to the transplanting of a layer of III-V material onto silicon for example.

In the case of BSOI a wafer of silicon is first oxidised in order to obtain a layer of silicon dioxide, which will serve as buried oxide.

This wafer is then routed over a 1.5 mm wide zone which corresponds to the edge or the rollover edge of the wafer, as explained above.

The surface of the wafer is then cleaned, for example via chemical and/or mechano-chemical cleaning stages.

Its surface is bonded via molecular adhesion onto a second wafer, made in silicon, and the unit is annealed at 1100°C for 2 hours.

A surface edge grinding stage followed by a mechano-chemical polishing allows to thin the wafer down to the desired thickness in order to obtain the SOI substrate.

This said method can apply to the transplanting of III-V material such as AsGa or InP onto another material such as a semiconductor notably silicon.

This said method can also apply to the transplanting of semiconductor material such as Germanium or Germanium silicon (SiGe) onto a substrate made in another material such as a semiconductor, notably silicon.

Likewise, this method can be used to perform a transplanting of wafers of non-semiconductor material, for example wafers of insulating material such as glass or quartz, or piezoelectric material such as LiNbO3 or LiTaO3, which allows to obtain a perfectly routed thin film on a support of the same nature or of a different nature, for example a semiconductor substrate and notably silicon.

The wafers of material prepared and assembled according to the invention are wafers of "bulk" material. However, the invention applies to wafers that can contain all or part of a component, for example an electronic, and/or an electro-optic, and/or an optic, and/or a magnetic component or a MEMS.

## Claims

1. Method for transferring a layer (16, 28) of circuits or component, known as transplant layer, comprising:
the trimming of a first chamfered wafer (12, 22) of material, in which the transplant layer is made, at least around or on the periphery of this transplant layer, over a thickness ed less than the thickness e of the first wafer, but greater than the thickness of said transplant layer (16, 28) said trimming starting from the face (19) of the first wafer to be assembled with a second wafer, made of a semiconductor material or of a piezoelectric material, said trimming being performed over a width Ld, measured on a plane parallel to that of the first wafer, at least equal to the width L of the chamfered edge of said chamfered wafer, measured on the same plane;
- then the transferring of this layer onto a said second wafer (14, 24) of material.

2. Method as in claim 1, the first wafer previously being covered with a protective layer (18).

3. Method as in claim 2, the protective layer being eliminated locally, before trimming of the first wafer, in a zone located above the zone to be routed of the first wafer.

4. Method as in claim 3, the local elimination of the protective layer being performed via lithography and etching.

5. Method as in claim 2, the protective layer (18) being eliminated after trimming of the first wafer.

6. Method as in any of claims 1 to 5, in which a part of the material of the transplant layer is eliminated during trimming.

7. Method as in one of claims 1 to 6, the first wafer being chamfered and comprising at least a chamfered edge (5).

8. Method as in one of claims 1 to 7, comprising an additional trimming stage after assembling the first and second wafers.

9. Method as in one of claims 1 to 8, the trimming stage being performed over a thickness ed of the first wafer of between 1 µm and 100 µm.

10. Method as in any of claims 1 to 9, the trimming stage being performed over a width Ld, measured on a plane parallel to that of the first wafer, at least equal to the width of the zone of this first wafer which cannot, without trimming, be assembled with the second wafer.

11. Method as in any of claims 1 to 10, the trimming stage being performed over a width Ld, measured on a plane parallel to that of the first wafer of between 100 µm and 5 mm.

12. Method as in any of the previous claims, the first wafer having a weakened plane (26) defining a thin layer in the wafer.

13. Method as in the previous claim, the first wafer being routed over a thickness greater than that of the thin layer.

14. Method as in claim 13, followed by:
- a thinning out stage via separation of the first wafer along the weakened plane, so as to leave the thin layer on the second wafer and leave a free portion (23) of the first substrate;
- a new creating stage of a new weakened plane in the portion (23) that remained free of the first substrate;
- an assembling stage of this portion (23) with a third substrate.

15. Method as in any of claims 12 to 14, the weakened plane being performed via ion implantation or via the creating of a buried porous zone or via the creating of a removable bonding interface.

16. Method as in any of claims 1 to 15, the first wafer comprising a lateral shoulder (25), eliminated during the trimming stage.

17. Method as in any of claims 1 to 16, the assembling of the two substrates being performed via molecular adhesion or via bonding using an adhesive substance.

18. Method as in any of the previous claims, components or circuits (16) having been made in the first wafer before trimming.

19. Method as in any of the previous claims, the trimming taking place after a previous surface preparation stage of the first wafer with the purpose of assembling or transplanting.

20. Method as in any of claims 1 to 19, the trimming taking place before a surface preparation stage of the first wafer with the purpose of assembling or transferring.

21. Method as in any of the previous claims, the trimming being performed via mechanical or chemical or mechano-chemical etching or polishing or via plasma etching or via a combination of at least two of these types of etching.

22. Method as in any of the previous claims, at least one of the two wafers being made in a semiconductor material.

23. Method as in the previous claim, said first wafers being made in silicon or in a III-V type semiconductor material.

24. Method as in any of claims 1 to 23, at least one of the two wafers being made in Germanium or in Germanium silicide (SiGe) or in a piezoelectric material or said first wafer being made in an insulating material.

25. Method as in any of the previous claims, the trimming stage being performed in a regular manner around the first wafer.

26. Method as in any of claims 1 to 24, the trimming stage being performed in an irregular manner around the first wafer, creating a lateral flat surface (44).

27. Method as in any of claims 1 to 24 or 26, the trimming stage being performed in an irregular manner, creating a marking zone (50 and 51).

28. Method as in claim 27, further comprising a marking stage of the first wafer.

29. Method as in one of claims 1 to 28, the second wafer being chamfered and comprising at least a chamfered edge.

## Patentansprüche

1. Verfahren zum Übertragen einer Schicht (16, 28) von Schaltungen oder Komponenten, die als Transplantatschicht bekannt ist, wobei das Verfahren umfasst:
- Fräsen eines ersten abgefasten Wafers (12, 22) aus Material, in dem die Transplantatschicht hergestellt ist, wenigstens um den oder an dem Umfang dieser Transplantatschicht über eine Dicke ed kleiner als die Dicke e des ersten Wafers, aber größer als die Dicke der Transplantatschicht (16, 28), wobei das Fräsen von der Fläche (19) des ersten Wafers, die mit einem zweiten Wafer montiert werden soll, der aus einem Halbleitermaterial oder aus einem piezoelektrischen Material hergestellt ist, beginnt, wobei das Fräsen über eine Breite Ld, gemessen in einer Ebene parallel zu der des ersten Wafers, ausgeführt wird, die wenigstens gleich der Breite L der abgefasten Kante des abgefasten Wafers, gemessen in derselben Ebene, ist;
- daraufhin Übertragen dieser Schicht auf einen zweiten Wafer (14, 24) aus Material.

2. Verfahren nach Anspruch 1, wobei der erste Wafer zuvor mit einer Schutzschicht (18) bedeckt wird.

3. Verfahren nach Anspruch 2, wobei die Schutzschicht in einer Zone, die sich über der Zone, die von dem ersten Wafer ausgefräst werden soll, befindet, lokal beseitigt wird, bevor der erste Wafer gefräst wird.

4. Verfahren nach Anspruch 3, wobei die lokale Beseitigung der Schutzschicht über Lithographie und Ätzen ausgeführt wird.

5. Verfahren nach Anspruch 2, wobei die Schutzschicht (18) nach dem Fräsen des ersten Wafers beseitigt wird.

6. Verfahren nach einem der Ansprüche 1 bis 5, in dem ein Teil des Materials der Transplantatschicht während des Fräsens beseitigt wird.

7. Verfahren nach einem der Ansprüche 1 bis 6, wobei der erste Wafer abgefast ist und wenigstens eine abgefaste Kante (5) umfasst.

8. Verfahren nach einem der Ansprüche 1 bis 7, wobei das Verfahren eine zusätzliche Phase des Fräsens nach dem Montieren des ersten und des zweiten Wafers umfasst.

9. Verfahren nach einem der Ansprüche 1 bis 8, wobei die Phase des Fräsens über eine Dicke ed des ersten Wafers von zwischen 1 µm und 100 µm ausgeführt wird.

10. Verfahren nach einem der Ansprüche 1 bis 9, wobei die Phase des Fräsens über eine Breite Ld, gemessen in einer Ebene parallel zu der des ersten Wafers, die wenigstens gleich der Breite der Zone dieses ersten Wafers ist, die ohne Fräsen nicht mit dem zweiten Wafer montiert werden kann, ausgeführt wird.

11. Verfahren nach einem der Ansprüche 1 bis 10, wobei die Phase des Fräsens über eine Breite Ld, gemessen in einer Ebene parallel zu der des ersten Wafers, von zwischen 100 µm und 5 mm ausgeführt wird.

12. Verfahren nach einem der vorhergehenden Ansprüche, wobei der erste Wafer eine abgeschwächte Ebene (26) aufweist, die in dem Wafer eine dünne Schicht definiert.

13. Verfahren nach dem vorhergehenden Anspruch, wobei der erste Wafer über eine größere Dicke als die der dünnen Schicht abgefräst wird.

14. Verfahren nach Anspruch 13, gefolgt von:
- einer Phase des Ausdünnens über Trennen des ersten Wafers entlang der abgeschwächten Ebene, um auf dem zweiten Wafer die dünne Schicht zu lassen und einen freien Abschnitt (23) des ersten Substrats zu lassen;
- einer Phase des Neuerzeugens einer neuen abgeschwächten Ebene in dem Abschnitt (23), der frei von dem ersten Substrat geblieben ist;
- einer Phase der Montage dieses Abschnitts (23) mit einem dritten Substrat.

15. Verfahren nach einem der Ansprüche 12 bis 14, wobei die Versprödungsebene über Ionenimplantation oder über das Erzeugen einer vergrabenen porösen Zone oder über das Erzeugen einer abnehmbaren Bondinggrenzfläche ausgeführt wird.

16. Verfahren nach einem der Ansprüche 1 bis 15, wobei der erste Wafer eine seitliche Schulter (25) umfasst, die während der Phase des Fräsens beseitigt wird.

17. Verfahren nach einem der Ansprüche 1 bis 16, wobei das Montieren der zwei Substrate über molekulare Adhäsion oder über Bonden unter Verwendung eines Haftmittels ausgeführt wird.

18. Verfahren nach einem der vorhergehenden Ansprüche, wobei die Komponenten oder Schaltungen (16) in dem ersten Wafer vor dem Fräsen hergestellt worden sind.

19. Verfahren nach einem der vorhergehenden Ansprüche, wobei das Fräsen nach einer vorhergehenden Phase der Oberflächenvorbereitung des ersten Wafers mit dem Ziel des Montierens oder Transplantierens stattfindet.

20. Verfahren nach einem der Ansprüche 1 bis 19, wobei das Fräsen vor einer vorhergehenden Phase der Oberflächenvorbereitung des ersten Wafers mit dem Ziel des Montierens oder Übertragens stattfindet.

21. Verfahren nach einem der vorhergehenden Ansprüche, wobei das Fräsen über mechanisches oder chemisches oder chemisch-mechanisches Ätzen oder Polieren oder über Plasmaätzen oder über eine Kombination wenigstens zweier dieser Ätztypen ausgeführt wird.

22. Verfahren nach einem der vorhergehenden Ansprüche, wobei wenigstens einer der zwei Wafer in einem Halbleitermaterial hergestellt wird.

23. Verfahren nach dem vorhergehenden Anspruch, wobei der erste Wafer in Silicium oder in einem Halbleitermaterial vom III-V-Typ hergestellt wird.

24. Verfahren nach einem der Ansprüche 1 bis 23, wobei wenigstens einer der zwei Wafer in Germanium oder in Germaniumsilicid (SiGe) oder einem piezoelektrischen Material hergestellt wird oder wobei der erste Wafer in einem Isoliermaterial hergestellt wird.

25. Verfahren nach einem der vorhergehenden Ansprüche, wobei die Phase des Fräsens auf regelmäßige Art und Weise um den ersten Wafer ausgeführt wird.

26. Verfahren nach einem der Ansprüche 1 bis 24, wobei die Phase des Fräsens auf unregelmäßige Weise um den ersten Wafer ausgeführt wird, wobei eine ebene Oberfläche (44) erzeugt wird.

27. Verfahren nach einem der Ansprüche 1 bis 24 oder 26, wobei die Phase des Fräsens auf unregelmäßige Weise ausgeführt wird, wobei eine Markierungszone (50 und 51) erzeugt wird.

28. Verfahren nach Anspruch 27, das ferner eine Phase des Markierens des ersten Wafers umfasst.

29. Verfahren nach einem der Ansprüche 1 bis 28, wobei der zweite Wafer abgefast wird und wenigstens eine abgefaste Kante umfasst.

## Revendications

1. Procédé de report d'une couche (16, 28) de matériau ou de circuits ou de composants, dite couche à reporter, comportant :
- le détourage d'une première plaque (12, 22) de matériau, dans laquelle la couche à reporter est réalisée, au moins autour ou à la périphérie de cette couche à reporter, sur une épaisseur ed inférieure à l'épaisseur e de la première plaque, mais supérieure à l'épaisseur de la couche (16, 28) à reporter, le détourage commençant de la face (19) de la première plaque à assembler avec une deuxième plaque, en matériau semi-conducteur ou en matériau piézoélectrique, l'étape de détourage étant réalisée sur une largeur Ld, mesurée dans un plan parallèle à celui de la première plaque, au moins égale à la largeur L du bord chanfreiné, mesurée dans le même plan ;
- le report de cette couche sur ladite deuxième plaque (14, 24) de matériau.

2. Procédé selon la revendication 1, la première plaque étant préalablement recouverte d'une couche (18) de protection.

3. Procédé selon la revendication 2, la couche de protection étant éliminée localement, avant détourage de la première plaque, dans une zone située au-dessus de la zone à détourer de la première plaque.

4. Procédé selon la revendication 3, l'élimination locale de la couche de protection étant réalisée par lithographie et gravure.

5. Procédé selon la revendication 2, la couche (18) de protection étant éliminée après détourage d'une première plaque.

6. Procédé selon l'une des revendications 1 à 5, dans lequel on élimine, lors du détourage, une partie du matériau de la couche à reporter.

7. Procédé selon l'une des revendications 1 à 6, dans lequel la première plaque est chanfreinée et comporte au moins un bord chanfreiné (5).

8. Procédé selon l'une des revendication 1 à 7, comportant une étape de détourage complémentaire après assemblage des première et deuxième plaques.

9. Procédé selon l'une des revendications 1 à 8, l'étape de détourage étant réalisée sur une épaisseur ed de la première plaque comprise entre 1 µm et 100 µm.

10. Procédé selon l'une des revendications 1 à 9, l'étape de détourage étant réalisée sur une largeur Ld, mesurée dans un plan parallèle à celui de la première plaque, au moins égale à la largeur de la zone de cette première plaque qui ne pourrait, sans détourage, être assemblée avec la deuxième plaque

11. Procédé selon l'une des revendications 1 à 10, l'étape de détourage étant réalisée sur une largeur Ld, mesurée dans un plan parallèle à celui de la première plaque, comprise entre 100 µm et 5 mm.

12. Procédé selon l'une des revendications précédentes, la première plaque présentant un plan de fragilisation (26) définissant une couche mince dans la plaque.

13. Procédé selon la revendication précédente, la première plaque étant détourée sur une épaisseur supérieure à celle de la couche mince.

14. Procédé selon la revendication 13, suivi :
- d'une étape d'amincissement par séparation de la première plaque le long du plan de fragilisation, pour laisser subsister la couche mince sur la deuxième plaque et pour laisser libre une portion (23) du premier substrat,
- d'une nouvelle étape de formation d'un nouveau plan de fragilisation dans la portion (23) du premier substrat restée libre,
- d'une étape d'assemblage de cette portion (23) avec un troisième substrat.

15. Procédé selon l'une des revendications 12 à 14, le plan de fragilisation étant réalisé par implantation ionique ou par formation d'une zone poreuse enterrée ou par formation d'une interface de collage démontable.

16. Procédé selon l'une des revendications 1 à 15, la première plaque comportant un épaulement (25) latéral, éliminé lors de l'étape de détourage.

17. Procédé selon l'une des revendications 1 à 16, l'assemblage des deux substrats étant réalisé par adhésion moléculaire, ou par collage à l'aide d'une substance adhésive.

18. Procédé selon l'une des revendications précédentes, des composants ou des circuits (16) ayant été réalisés dans la première plaque avant détourage.

19. Procédé selon l'une des revendications précédentes, le détourage ayant lieu après une étape préalable de préparation de surface de la première plaque en vue de l'assemblage ou du report.

20. Procédé selon l'une des revendications 1 à 19, le détourage ayant lieu avant une étape préalable de préparation de surface de la première plaque en vue de l'assemblage ou du report.

21. Procédé selon l'une des revendications précédentes, le détourage étant réalisé par attaque mécanique ou chimique ou mécano-chimique ou par polissage ou par attaque par plasma ou par combinaison d'au moins deux de ces types d'attaque.

22. Procédé selon l'une des revendications précédentes, au moins une des deux plaques étant en matériau semi-conducteur

23. Procédé selon la revendication précédente, la première plaque étant en silicium ou en matériau semi-conducteur de type III-V.

24. Procédé selon l'une des revendications 1 à 23, au moins une des deux plaques étant en Germanium ou en siliciure de Germanium (SiGe) ou en un matériau piézoélectrique ou la première plaque étant en un matériau isolant.

25. Procédé selon l'une des revendications précédentes, l'étape de détourage étant réalisée de manière régulière autour de la première plaque.

26. Procédé selon l'une des revendications 1 à 24, l'étape de détourage étant réalisée de manière irrégulière autour de la première plaque, formant ainsi une surface latérale plane (44).

27. Procédé selon l'une des revendications 1 à 24 ou 26, l'étape de détourage étant réalisée de manière irrégulière, formant ainsi une zone de marquage (50 et 51).

28. Procédé selon la revendication 27, comportant en outre une étape de marquage de la première plaque.

29. Procédé selon l'une des revendications 1 à 28, dans lequel la deuxième plaque est chanfreinée et comporte au moins un bord chanfreiné.
